# EUROPEAN PATENT APPLICATION

(11) **EP 1 331 287 A2**
(43) Date of publication of application: **30.07.2003**
(21) Application number: 03250467.2
(22) Date of filing: 24.01.2003
(51) Int. Cl.: C23C 22/52, C23F 1/18, H05K 3/38

(54) **Treating metal surfaces with a modified oxide replacement composition**

(30) Priority: 24.01.2002 US 351694 P
(71) Applicant: Shipley Co. L.L.C., Marlborough, MA 01752 (US)
(72) Inventor: Bayes, Martin W., Hopkinton, Massachusetts 01748 (US)
(74) Representative: Kent, Venetia Katherine

(57) **Abstract**

A method for treating a metal surface to microroughen the metal surface without forming a reddish brown to black oxide film on the metal surface. Modified oxide replacement compositions derived from oxide replacement compositions are prepared by altering the amount of at least one component in the oxide replacement composition to a level above or below an optimized amount of that component in the oxide replacement composition. The modified oxide replacement composition is then used to microroughen a metal surface without the oxide film forming on the metal. A temporary photoresist may be laminated on the treated metal surface and portions of the photorcist developed and stripped from the metal without concern for resist lock-in occurring.

## Description

### Background of the Invention

The present invention is directed to a method for treating a metal surface with a modified oxide replacement composition. More specifically, the present invention is directed to a method for treating a metal surface with a modified oxide replacement composition for receiving a polymer material.

Multilayer printed circuit boards are used for a variety of electrical applications and provide the advantage of conservation of weight and space. A multilayer board is comprised of two or more circuit layers, and each circuit layer is separated by one or more layers of dielectric material. Circuit layers are formed by applying a copper layer onto a polymeric substrate. Printed circuits are then formed on the copper layers by techniques well known in the art. Such techniques, for example, include print and etch to define and produce the circuit traces, i.e., discrete circuit lines in a desired circuit pattern. Once the circuit lines are formed, a stack is formed composed of multiple circuit layers separated from each other by a dielectric layer such as epoxy. Once the stack is formed, it is subjected to heat and pressure to form the laminated multilayer circuit board.

Following lamination, the multiple circuit layers are electrically connected to each other by drilling through-holes through the board surface. Resin smear from through-hole drilling is removed under rather stringent conditions, for example, by treatment with a concentrated sulfuric acid or hot alkaline permanganate solution. Thereafter, the through-holes are further processed and plated to provide a conductive interconnecting surface.

Prior to lamination and through-hole formation, the discrete copper circuit lines are treated with an adhesion promoter to improve bond strength between each circuit layer and adjacent interleaving dielectric resin layers. One method used by the art to improve bond strength involves oxidative treatment of the copper circuit lines to form a copper oxide surface coating on the circuit lines. The oxide coating may be a reddish brown, brown or black oxide film that adheres well to copper. The oxide possesses significantly more texture or roughness than an untreated copper surface. Oxide films may be formed using highly alkaline solutions containing an oxidizing agent such as sodium chlorite as disclosed in U.S. Pat. No. 4,844,981. Chemical treatments that produce adherent conversion coatings on metal surfaces, such as black oxide, are very often used to promote adhesion of polymeric materials to metals. Such roughened and conversion coated, surfaces enhance adhesion and wetability to the adjacent insulating layer by a mechanism that is believed to include mechanical interlocking between a metal surface and a dielectric resin layer. Metal surfaces that have been microetched, but not conversion coated, do not possess as high a degree of surface roughness and texture, as can be inferred from their greater reflection of visible light.

Acidic materials used to remove resin smear have a tendency to dissolve the copper oxide on the circuit lines where exposed in a through-hole. Dissolution of copper oxide results in interference with the bond between the circuit lines and the dielectric resin material and often causes a condition known in the art as "pink-ring". To reduce the susceptibility of the oxide to such attack, the oxide treatment described above is often followed by a step of converting the copper oxide to a form less soluble in acid while retaining enhanced surface roughness. Such processes include reduction of the oxide by treatment with a reducing solution such as diethylamine borane as disclosed in U.S. Pat. No. 4,462,161, an acid solution of selenium dioxide as disclosed in U.S. Pat. No. 4,717,439, or a sodium thiosulfate solution as disclosed in U.S. Pat. No.5,492,595. An alternative approach involves partial or complete dissolution of the oxide layer to provide a copper surface having enhanced texture as disclosed in U.S. Pat. No. 5,106,454.

Other techniques known in the art to promote adhesion between copper surfaces and dielectric resins prior to multilayer lamination include the use of etches inclusive of cupric chloride etchants, mechanical treatments designed to produce surface texture, and metal plating, all designed to produce roughened surfaces. Electrolytic metal plating processes may provide highly roughened surfaces and are used to enhance adhesion of continuous sheets of copper to epoxy for formation of copper circuit board laminates. However, the innerlayers of a printed circuit board contain many electrically discrete circuit traces that prevent use of a process requiring electrical connection to all areas to be plated.

Oxidizing solutions containing peroxide have been used for a variety of purposes including removal of oxide scale, cleaning of surfaces, creation of smoother, brighter metallic surfaces and creation of microroughened metal surfaces. For example, in CA-A-1250406, metals such as iron, copper or their alloys are treated using a solution containing hydrogen peroxide for metal pickling or polishing. The hydrogen peroxide based compositions have been developed, each comprising a different type of stabilizing system.

For use in the printed circuit industry, hydrogen peroxide etching solutions are known and have been described as etchant compositions for use in an etching step for forming a copper circuit pattern from copper laminate mounted on an insulating layer protected in a pattern corresponding to a final desired circuit pattern. The foil is then contacted with the etching solution and the unprotected copper leaving the desired circuit pattern. During the etching process, the copper foil contacted with the hydrogen peroxide-based compositions is etched away for complete removal. Peroxide etchants are described, for example, in U.S. Pat. Nos. 4,130,454 and 4,859,281.

U.S. Pat. No. 5,800,859 discloses a hydrogen peroxide containing aqueous composition used on a copper surface that allegedly forms a microroughened conversion-coated surface to provide a porosity that forms a strong bond with an organic layer. Such a copper surface is desirable in preparation of multilayer circuit boards. The patent discloses that a process is provided for treating a metal surface by contacting the conducting layer of a circuit with an adhesion promotion composition containing 0.1 to 20% by weight hydrogen peroxide, an inorganic acid, an organic corrosion inhibitor (conversion coater) and a surfactant in an adhesion promotion step to form a microroughened conversion-coated surface. Surfactant amounts range from 0.001% to no greater than 5% by weight of the composition. The '859 patent discloses that the process is useful for forming multilayer printed circuit boards containing at least one insulating layer and at least one conducting layer. The innerlayer contains at least one insulating layer and at least one conducting layer. The outerlayer contains at least an insulating layer in which the conducting layer is the metal surface treated with the peroxide composition. After adhesion promotion a polymeric material is joined directly to the conducting layer or the outerlayer or for direct adhesion to the insulating layer of the outerlayer. The patent further discloses that the process may be used to provide a microroughened surface to which polymeric materials such as photoimageable resins, solder masks, adhesives or polymeric etch resists have improved adhesion in the manufacture of printed circuit boards. The document also alleges that the process is advantageous because the process overcomes the need for forming a black or brown copper oxide layer. However, many formulations disclosed therein still form a dark film on a copper surface.

In addition to forming a dark film on a copper surface, another disadvantage of the adhesion promotion composition of the '859 patent is the presence of a surfactant in the formulation. Formulations containing surfactants often are difficult to use in the spray mode of application because of excessive foaming of the formulation. Rinsing of the surfactant from a surface often is difficult because a surfactant can bond to a surface. When surfactant is left on the surface, the surfactant may interfere with bond strength between the oxide layer and the surface adhered to the layer.

DE 197 32 419 A1 discloses an etching composition for microroughening copper that replaces the black oxide forming method. The etching composition contains oxyacids, peroxides, an azole, and a halide. The patent discloses oxyacids in amounts of from 40 g/L to 300 g/L, peroxides or derivatives thereof from 20 g/L to 30 g/L, azoles from 0.1 g/L to 20 g/L, and chloride from 0.0006 g/L to 2 g/L.

U.S. Pat. No. 6,020,029 discloses a composition and method for microroughening a copper surface to receive a polymeric material. The composition contains an oxidizer, an acid, a corrosion inhibitor, a halide source and a polymer. After treating the copper surface with the composition, an alkaline solution is applied to the treated surface to improve adhesion between the copper surface and a polymeric material. Such polymeric materials include pre-preg materials, imageable dielectrics, photoimageable resins, soldermasks, adhesives or polymeric etch resists. The composition is directed to reduce or eliminate pink-ring and resin void flaws.

U.S. Pat. No. 6,054,061 discloses an adhesion promotion composition that microroughens and conversion coats a metal surface. The composition contains 0.1 to 20% by weight of hydrogen peroxide, one or more organic acids, an amine quaternary ammonium compound free of surfactant substitutents and optionally a corrosion inhibitor. The composition is free of surfactants. Surfactants are eliminated because they may interfere with bond strength between the oxide coating on the metal surface and the material adhered to the metal as discussed above. The composition may be used to replace the less desirable black copper oxide adhesion promotion process. Compositions of the '061 patent produce a reddish brown to dark brown coating on the metal surface that are indicative of a more desirable thickness and are more robust to subsequent handling than black oxide coatings which are excessive and powdery. Such conversion coatings form a film on the microroughened surface to assist in adhesion promotion and inhibit further oxidation of the microroughened surface. Polymeric material that may be applied to the microroughened surface includes pre-preg, polymeric photoresist, screenresist solder mask and adhesive material.

Adhesion promotion compositions, also known as oxide replacement compositions, as described above may be applied to metal surfaces by many different methods. Examples of such methods include dipping the metal into a bath of the adhesion promotion composition or spraying the adhesion promotion composition on the metal and collecting any run-off. When metal concentrations increase to levels such that the adhesion promotion composition is no longer effective for its intended purpose, it may be replaced with a new batch, or metal content of the composition may be reduced and then maintained at a steady state. Steady state mode may be maintained by a number of methods known in the industry. One such method involves continuously bailing out or siphoning off a stream of spent adhesion promotion composition while simultaneously adding components to the composition to maintain its desired function. Such bailout streams may contain hydrogen peroxide, acids, metals, such as copper, and other additives that compose adhesion promotion compositions. Dissolved metals in the bailout streams come from metal surfaces treated with the adhesion promotion composition. The spent adhesion promotion compositions or spent oxide replacement compositions, including bailout streams, are normally waste treated to remove or reduce the metal content and other unwanted materials. Residue material then is disposed of according to both state and federal laws. Waste treatment methods include resin exchange methods, electrochemical treatments, and the like to remove various contaminants. Resin exchange methods often require skilled workers to handle the resins thus adding to the expense of the procedure. Also, ion exchange resins are costly and may collapse during operation requiring employment of additional resin and additional expense. Electrochemical treatments also are costly due to employment of expensive apparatus and skilled workers. Additionally, such electrochemical treatments require considerable time in operation to remove contaminants from spent adhesion promotion compositions.

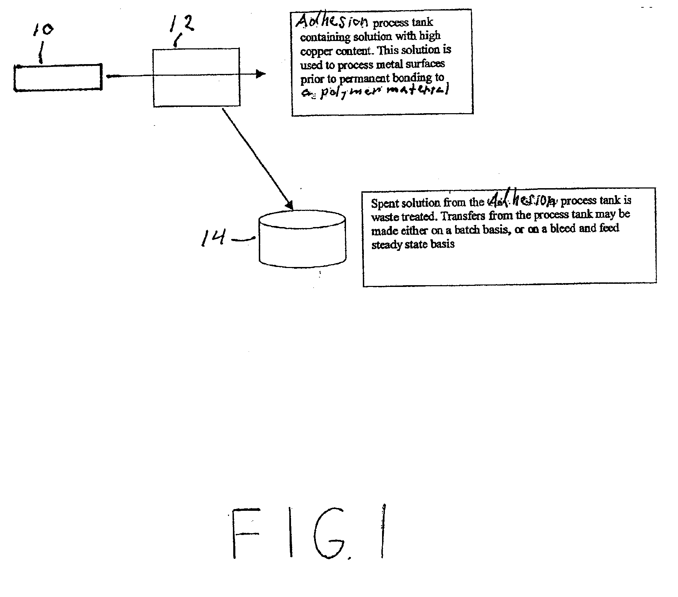

Figure 1 shows a schematic for a process for utilizing an adhesion promotion composition or oxide replacement composition. A circuit board with a metal surface **10**, such as copper, is treated with an oxide replacement composition in tank **12** to microroughen the metal surface and form a reddish brown to black oxide film on the microroughened surface to prepare the metal surface to receive a permanent polymer material. The polymer material may be a photoresist or pre-preg. The process of treating circuit board **10** with the oxide replacement composition may be a horizontal or vertical process. After circuit board **10** is laminated with a permanent polymer material, circuit board **10** undergoes further processing to form a multilayer printed circuit board (steps not shown).

Repeated treatment of boards with the oxide replacement composition in tank **12** results in the concentration of metal in the oxide replacement composition to rise and contaminate the composition. When the oxide replacement composition changes such that it no longer effectively microroughens a metal surface, the oxide replacement composition is spent. The spent oxide replacement composition in tank **12** may be replaced by a new batch of oxide replacement composition. Alternatively, the oxide replacement composition may be maintained at a steady state by a "bleed and feed" process. To maintain the steady state, sufficient amounts of spent oxide replacement composition are removed or bailed out of tank **12** and new components are added. Specific gravity of the oxide replacement composition may be used as an indicator to initiate bailout. The spent oxide replacement composition is then transferred to waste treatment tank **14**. The spent oxide replacement composition is treated to remove contaminants, especially excess metal, by suitable methods known in the art, and properly discarded.

Metal surfaces microroughened with oxide replacement compositions are generally limited in the types of polymeric material that may be applied to them. Application of the oxide replacement composition to a metal surface provides a mircroroughened surface that is too roughened, i.e., a reddish brown to black oxide film, for the application of temporary polymer materials such as unexposed temporary photoresists. Thus, such metal surfaces are limited to receiving permanent coatings such as a pre-preg laminate, soldermasks and the like.

In lithographic processes where an unexposed temporary photoresist is developed, the highly microroughened metal surface undesirably may retain unexposed photoresist residues. Such a phenomena is referred to as resist lock-in. Such residues may prevent proper etching thus, resist lock-in, or incomplete photoresist removal, can lead to defective lithographic patterns and to electrical shorts in the final product. Resist lock-in is especially problematic in innerlayer imaging pretreatment processes in printed wiring board manufacturing. Examples of innerlayers of printed wiring boards are disclosed in U.S. 5,137,618, U.S. 5,528,826, and U.S. 5,779,870.

As electronic devices become smaller, high density printed wiring boards are needed. In a high density printed wiring board, the printed wiring is small and the spacing there-between is small in order to achieve high density. Printed wiring lines may be as small as 0.075 millimeters or smaller and spaces as small as 0.075 millimeters or smaller may be achieved. A problem with very fine-line printed wiring board structure is that it is difficult to make the printed wiring board circuit pattern free of defects such as are caused by resist lock-in. Because of the miniaturization of the circuitry, even micron size particles of photoresist may lead to short circuiting. Thus, yield of an innerlayer panel with many such fine line circuit patterns can be very low. Accordingly, methods of reducing or eliminating resist lock-in are highly desirable.

U.S. Pat. No. 5,800,859, discussed above, alleges that one of its adhesion promotion compositions does not suffer from the phenomena of resist lock-in. However, as mentioned above, the formulations disclosed in the '859 patent form a dark film on a copper surface, and formulations containing surfactants are undesirable for use in adhesion promotion compositions. The adhesion promotion composition allegedly may be employed for forming multilayer printed circuit boards having both inner and outer layers.

U.S. Pat. No. 5,545,466 discloses a method of treating a matte copper surface with a polishing composition composed of cupric chloride, hydrochloric acid and hydrogen peroxide to prevent resist lock-in. The matte copper surface is treated to provide a roughness in the range within about 2.0 to 7.5 µm.

U.S. Pat. No. 5,679,230 also discloses a method that allegedly avoids the resist lock-in problem. The '230 patent discloses a method that electrolytically treats copper on the matte side by depositing micro-nodules of a metal or metal alloy that allegedly improves adhesion but not roughness. Deposits have a roughness Rz of about 4-7.5 µm.

Although there are methods that address the resist lock-in problem, there is still a need for an additional method to prevent the reddish brown to black oxide film that forms on a metal surface during microroughening with an oxide replacement composition and to prevent resist lock-in.

### Summary of the Invention

The present invention is directed to treating a metal surface by changing at least one component of an oxide replacement composition by a sufficient amount to form a modified oxide replacement composition such that the modified oxide replacement composition does not form a colored film of reddish brown to black oxide on the metal surface when the metal surface is contacted with the modified oxide replacement composition; and contacting the metal surface with the modified oxide replacement composition to microroughen the metal surface. Such components as acids, oxidizers, corrosion inhibitors, halogens and adjuvants may be quantitatively altered in an oxide replacement composition such that the modified oxide replacement composition does not form a reddish brown to black oxide film on a metal surface, but yet microroughens the metal surface.

Advantageously, the microroughened metal surface is sufficiently rough to receive a temporary substrate such as a polymer material without concern by workers that an overly strong bond is formed between the substrate and metal surface such that resist lock-in occurs. The method of the present invention is especially suitable for applications involving placing temporary polymer substrates on a metal surface. Such applications are employed in the electronics industry in the manufacture of multilayer printed circuit or wiring boards. Temporary photoresist may be laminated on a circuit board metal layer, especially an innerlayer, to form a circuit pattern on the metal layer. After exposure, the unexposed temporary photoresist is developed without concern for resist lock-in. Resist lock-in may interfere with etching, and may cause electrical shorts in printed circuit boards. Advantageously, the modified oxide replacement composition and method of the present invention prevent the reddish brown to black oxide film formation which in turn substantially reduces or eliminates resist lock-in. Accordingly, electrical shorts and other defects in printed wiring boards caused by incomplete resist removal are reduced or eliminated.

Additionally, another advantage of the present invention is that the method of the present invention provides a more economical re-use of oxide replacement compositions. Spent oxide replacement compositions need not be waste treated. Thus, prolonged and costly procedures for removing contaminants by ion exchange and electrochemical methods of purification are eliminated. Instead, the amount of at least one component of the oxide replacement composition is sufficiently altered such that the modified oxide replacement composition does not form a reddish brown to black film on a treated metal surface. Altering or modifying component amounts do not employ time consuming and costly equipment of waste treatment. Thus the method of the present invention provides for an efficient use of spent oxide replacement compositions.

A primary objective of the present invention is to provide a method of microroughening a metal surface such that a reddish brown to black oxide film is not formed on a metal surface.

Another objective of the present invention is to provide a method of microroughening a metal surface for the reception of a temporary polymer material.

An additional objective of the present invention is to provide a method for microroughening a metal surface such that the phenomena of resist lock-in is reduced or eliminated.

A further objective of the present invention is to provide an economically efficient method for re-using an oxide replacement composition.

Additional objectives and advantages of the present invention may be ascertained by those of skill in the art by reading the detailed description of the invention and the appended claims.

### Brief Description of the Drawings

The file of this patent contains at least one drawing executed in color. Copies of this patent with color drawing(s) will be provided by the Patent and Trademark Office upon request and payment of the necessary fee.
Figure 1 is a schematic illustrating a method of using and treating oxide replacement compositions; and
Figure 2 is a color chart contrasting colors observed on a copper surface treated with an oxide replacement composition or treated with a modified oxide replacement composition.
Figure 3 is a schematic illustrating a method of utilizing a modified oxide replacement composition of the present invention.

### Detailed Description of the Invention

The present invention is directed to treating a metal surface by changing at least one component of an oxide replacement composition by a sufficient amount to form a modified oxide replacement composition such that the modified oxide replacement composition does not form a reddish brown to black oxide film on the metal surface when the metal surface is contacted with the modified oxide replacement composition; and contacting the metal surface with the modified oxide replacement composition to microroughen the metal surface. Modifying an oxide replacement composition involves adding or reducing oxide replacement composition components to deoptomize the oxide replacement composition. An optimized oxide replacement composition as defined within the scope of the present invention means an oxide replacement composition that causes the formation of a reddish brown to black oxide film on a surface of a metal substrate. Accordingly, a modified oxide replacement composition is a deoptimized oxide replacement composition that does not cause the formation of a reddish brown to black oxide film on a surface of a metal substrate but yet microroughens the surface of a metal substrate. A microroughened metal substrate that is microroughened with the modified oxide replacement composition and method of the present invention is adapted for receiving a temporary substrate such as a polymer material.

After the oxide replacement solution has been modified, the modified oxide replacement solution is applied to a metal surface to microroughen the metal surface such that a polymer material may form a desired temporary bond to the microroughened metal. The polymer may be a temporary photoresist which may be exposed to actinic radition and developed according to any suitable method in the art. Absence of the reddish brown to black oxide film on the microroughened metal surface permits removal of the unexposed portions of the photoresist without a concern for resist lock-in. The method and modified oxide replacement composition of the present invention are especially suitable for treating a metal surface to receive a temporary photoresist in manufacturing printed wiring boards as discussed below.

The method of the present invention may be employed to microroughen any suitable metal. Examples of such metals include, but are not limited to, copper, nickel, tin, iron, chromium, platinum, lead, gold, silver, cobalt, or alloys thereof. The method of the present invention is especially suitable for treating copper, nickel, tin or alloys thereof. The method of the present invention is most suitable for treating copper or copper alloys.

As discussed above, modified oxide replacement compositions are derived from oxide replacement compositions. Oxide replacement compositions, also known as adhesion promotion compositions, may be true solutions or suspensions. Oxide replacement compositions may be aqueous based solutions or suspensions, and may contain such components as an oxidizer, an acid, a corrosion inhibitor, a source of a halide ions, amine compounds, stabilizing agents, surfactants, water soluble polymers and other adjuvants. Adjuvants are subsidiary ingredients or additives in a composition which contribute to the effectiveness of primary ingredients. Specific components in a given oxide replacement composition may vary widely and the foregoing list is not exhaustive.

Oxidizers that are used in oxide replacement compositions include any oxidizer that is capable of oxidizing a metal surface. Examples of such oxidizers include, but are not limited to, hydrogen peroxide, permanganates such as potassium permanganate, and persulfates. Concentrations of such oxidizers in oxide replacement compositions range from about 0.01% to about 30% by weight or more of the composition. Preferably, oxidizers are at concentrations of from about 0.5% to about 15% by weight of the composition.

A particularly preferred oxidizer is hydrogen peroxide. Hydrogen peroxide is present in many oxide replacement compositions in a concentration of at least about 0.01% by weight active hydrogen peroxide up to a maximum of about 20% by weight. Preferably hydrogen peroxide concentrations vary between about 0.5% by weight to about 10% by weight. More preferably the hydrogen peroxide concentrations range from about 1.0% to about 5.0% by weight of the oxide replacement composition.

Acids contained in oxide replacement compositions include, but are not limited to, inorganic acids such as sulfuric acid, phosphoric acid, hydrochloric acid, hydrobromic acid, or mixtures thereof. Acid concentrations in oxide replacement compositions range from about 0.5% to about 50% by weight of the composition. Preferably, acids are in concentrations of from about 1% to about 30% by weight of the composition. In many oxide replacement compositions sulfuric acid is the preferred inorganic acid. Sulfuric acid may be employed in an amount of from about 5 grams/liter to about 360 grams/liter, preferably from about 70 grams/liter to about 110 grams/liter.

Corrosion inhibitors used in oxide replacement compositions are employed to react with a metal surface to conversion coat the metal surface. Corrosion inhibitors are present in oxide replacement compositions in an amount of at least about 0.0001% by weight, preferably at least about 0.0005% by weight of the adhesion promotion composition. Particularly desirable results are achieved with concentrations of at least about 0.1%, more preferably from about 0.5% by weight and most preferably at least about 1.0% by weight of the oxide replacement composition. Generally, corrosion inhibitors are in amounts no greater than 20% by weight of an oxide replacement composition.

Examples of corrosion inhibitors include, but are not limited to azole compounds such as, triazoles, benzotriazoles, tetrazoles, imidazoles, benzimidazoles, benzotriazoles substituted with, for example, C₁₋₄ alkyl substitutents, and the like.

While surfactants may be employed, preferably they are left out because they leave unwanted residues on metal substrates. Surfactants may be included in oxide replacement compositions in amounts of from at least about 0.001% by weight, preferably at least about 0.005% by weight or even about 0.01% by weight of the oxide replacement composition. Generally, the surfactant is present in amounts no greater than about 5% by weight, preferably no greater than about 3% by weight. When the concentration of the surfactant is increased significantly above about 5%, desired adhesion between a metal substrate and a polymer material may not be achieved. Examples of suitable surfactants include, but are not limited to, a C₁₀-C₄₀ surfactant, that is a surfactant containing at least one C₁₀-C₂₀ alkyl group. Surfactants may have at least one, preferably two, hydroxy lower alkyl groups, that is C₁-C₄hydroxyalkyl, and one or, less preferably, two lower alkyl, that is, C₁-C₄ alkyl groups, attached to a nitrogen atom.

Amines and quaternary ammonium compounds also may be employed in oxide replacement compositions. The term amine as used herein is defined as a lower aliphatic, cycloaliphatic or aromatic amine, i.e., a primary, secondary or tertiary amine having a C₁ to C₈ substitution. The term quaternary ammonium compound as used herein also is defined as a lower aliphatic, cycloaliphatic or aromatic compound. Each substituent on the amine may be aliphatic, cycloaliphatic or aromatic and each of such substituent may be further substituted with groups such as carboxyl, nitro, sulfonyl, hydroxyl, and the like. Exemplary amines include methylamine, dimethylamine, trimethylamine, ethylamine, triethylamine, tripropylamine, isopropylamine, triallylamine, n-butylamine, t-butylamine, n-amylamine, cyclohexylamine, dicyclohexylamine, and the like. Exemplary quaternary ammonium compounds include tetramethylammonium hydroxide, tetraethylammonium hydroxide, and dimethyldiethylammonium hydroxide. Amines are used in concentrations of from about 0.01% by weight to about 2.5% by weight and more preferably in concentrations of about 0.1% to about 1.0% by weight of the an oxide replacement composition. Preferably, amines do not have a fatty substitution or other surfactant group.

Any suitable compound that can provide a source of halogen ions may be employed. One source of halogen ions are alkali metal salts such as sodium chloride or potassium chloride, oxohalides such as sodium chlorate or potassium chlorate, or halide bearing mineral acids such as hydrochloric acid or hydrogen bromide. Suitable halogens include bromine, chlorine, fluorine and iodine. Preferably the source of halide ions provides chloride ions in the oxide and modified oxide replacement composition. The concentration of the source of halide ions may range from about 5 to about 500 milligrams/liter. Preferably the halide source is in an amount of from about 10 to about 50 milligrams/liter, all based on halide ion content.

Oxide replacement compositions also may contain a water soluble polymer. Such a polymer preferably is not a wetting agent or surfactant but is instead a water soluble homopolymer or copolymer of low molecular weight. Examples of suitable polymers include, but are not limited to, ethylene oxide, an ethylene oxide/propylene oxide copolymer, polyethylene glycols, polypropylene glycols or polyvinyl alcohols. Commercially available polymers of polyethylene glycol include Carbowax® sold by Union Carbide company such as Carbowax® 750 and Carbowax® MPEG 2000. Ethylene oxide polymers or ethylene oxide-propylene oxide copolymers are commercially available from BASF company under the tradename Pluronics®. Concentrations of water soluble polymers in oxide replacement compositions range from about 1 to about 15 grams/liter, preferably from about 3 to about 6 grams/liter.

Other components or adjuvants of oxide replacement compositions include, but are not limited to, stabilizing agents such as dipicolinic acid, diglycolic and thiodiglycolic acid, ethylene diamine tetraacetic acid and its derivatives, magnesium salts or an aminopolycarboxylic acid, sodium silicate, phosphonates and sulphonates.

Adjuvants such as stabilizing agents are included in oxide replacement compositions in an amount of from about 0.001% by weight, preferably at least about 0.005% by weight of the composition. Most preferably the concentration of the stabilizer ranges from about 0.5% to about 5% by weight of the composition.

To prepare a modified oxide replacement composition within the scope of the present invention, a worker may increase or decrease an amount of one or more of the above components or any component or compound that deoptimizes an oxide replacement composition such that a reddish brown to black oxide film does not form on a metal surface. Components may be readily increased above their optimum level by mixing or dissolving the components in an oxide replacement composition. Decreasing an amount of a component below its optimum level may be performed by any suitable method. Examples include adding a complexing agent such as EDTA(ethylenediaminetetracetate) to remove a component from solution, neutralizing an acid with a base, filtering a component out of solution, passing the oxide replacement composition through ion specific exchange resins, or filtering one or more component from the oxide replacement composition. For example, mineral acids such as phosphoric acid, sulfuric acid, HCI, HBr, and the like may be neutralized with a base such as sodium hydroxide or potassium hydroxide. Quaternary amines may be removed from a composition by a suitable ion exchange resin. Complexing agents such as EDTA may be employed to complex-out solubilized metals such as copper. Filters may be employed to filter-out surfactants, polymers and other relatively large molecules from an oxide replacement composition. There is no limit on the type of extraction method employed. The specific method depends on the specific component that is to be removed from the oxide replacement composition. Many such methods are known in the art and the list is not exhaustive. While a modified oxide replacement composition may be prepared by either increasing or decreasing the amount of a component of an oxide replacement composition, increasing a component is preferred. Decreasing a component, as discussed above, requires additional steps and sometimes costly apparatus such as ion exchange resins. Increasing a component involves adding a component in an amount in excess of the level the component is employed in an oxide replacement composition to form a reddish brown to black oxide film on a metal substrate. No additional costly materials are employed to increase component amounts.

Once a component is increased or decreased to deoptimize an oxide replacement composition, the resulting modified oxide replacement composition may be employed to microroughen a metal substrate. Generally, a component may be increased from about 1% of its weight in the oxide replacement composition to saturation level. Preferably, the component is increased from about 5% to about 25% of its weight and most preferably from about 10% to about 15% of its weight in the oxide replacement composition. When the component is decreased, generally the component is decreased from about 1% to about 100% of its weight in the oxide replacement composition. Preferably, a component is decreased from about 5% to about 30% of its weight, and most preferably from about 10% to about 15% of its weight in the oxide replacement composition.

Minor experimentation may be employed to determine how much of a component may be added or removed from an oxide replacement composition such that the modified oxide replacement composition does not form a reddish brown to black oxide film on a metal surface. A suitable test is macroscopic observation, i.e., naked eye, of a metal treated with a modified oxide replacement composition. If an oxide replacement composition causes a reddish brown, brown to black oxide film to form on a metal surface, the amount of any one of the components may be increased or decreased until a metal test sample does not macroscopically show a reddish brown, brown or black oxide film.

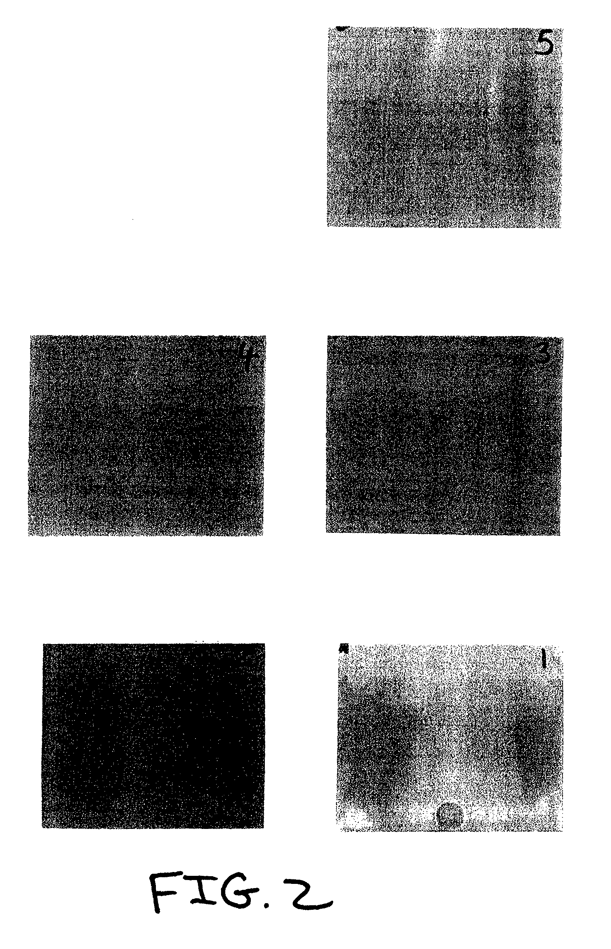

Figure 2 shows five color plates as examples of color ranges on copper metal treated with an oxide replacement composition or a modified oxide replacement composition. Color plates 1 to 4 show the color ranges of film formed on copper etched with an oxide replacement composition. Color plate 1 shows a mottled appearance. Color plate 2 is black to dark brown, color plate 3 is brown, and color plate 4 is a light brown. Such color ranges are unsuitable since resist lock-in occurs with such dark colored film on copper. Plate 5 shows a reddish pink color observable on a uniform copper surface treated with a modified oxide replacement composition of the present invention. While shades may vary depending on the specific oxide replacement or modified oxide replacement composition used, the color plates provide an indicator to direct a worker to know if the treated copper surface is adapted for receiving a temporary polymer material. Plate 5 shows the preferred color for a copper surface to receive a temporary photoresist. Copper with a yellow to orange color may not be suitable for receiving a temporary photoresist.

As mentioned above, the amount of any component of an oxide replacement composition may be altered above or below its optimum amount to make a modified oxide replacement composition. Preferably, halogen sources and/or corrosion inhibitors are increased in the oxide replacement composition. While the halogen ions and corrosion inhibitors may be increased by the amounts listed above, preferably halogen ions and corrosion inhibitors are increased in oxide replacement composition by about 2% by weight to about 15% by weight of the amount employed in the oxide replacement composition. More preferably, halogen ions and corrosion inhibitors are increased in an oxide replacement composition by about 5% to about 10% by weight of the amount used in the oxide replacement composition.

In addition to the components mentioned above, modified oxide replacement compositions may contain high concentrations of dissolved or suspended metals from oxide replacement compositions used to microroughen and conversion coat a metal surface. Metals may range from about 200 mg/liter to as high as 50 gm/liter and above. Copper may typically range from about 10 gm/liter to about 40 gm/liter.

The modified oxide replacement composition and method of the present invention are especially suitable for treating surfaces of metal substrates in the printed circuit board industry. In particular, the modified oxide replacement composition and method are especially suitable for treating metal surfaces of innerlayers of printed circuit boards. Such innerlayers are typically laminated with temporary polymer materials, such as temporary photoresists, for patterning circuitry. A phototool or photomask with a desired pattern is placed on the temporary photoresist and exposed to actinic radiation. Unexposed portions of the temporary photoresist are developed and exposed portions of metal are etched and the remainder of the photoresist is stripped. If resist lock-in occurs, a defective product may result. Advantageously, the modified oxide replacement composition and method of the present invention effectively reduces or eliminates the problem of resist lock-in by effectively reducing or eliminating reddish brown to black oxide film formation on metal surfaces. Thus, short circuiting and other defects caused by resist lock-in are prevented. As electronic devices become smaller to meet user needs, the density of components on the layers of the printed wiring boards necessarily is increased. Accordingly, the wiring is small and spacing is small to achieve high density. Thus, even micron size resist lock-in may cause a short circuit in a final product.

Modified oxide replacement compositions may be prepared from oxide replacement compositions obtained from a supplier or from bailout from an operational oxide replacement bath. In addition to preventing resist lock-in, the present invention provides for efficient use of bailout from operational oxide replacement baths. Instead of waste treating bailout streams or spent oxide replacement compositions, the streams may be made into modified oxide replacement compositions or baths for microroughening or etching a metal surface in preparation for receiving a temporary polymer material.

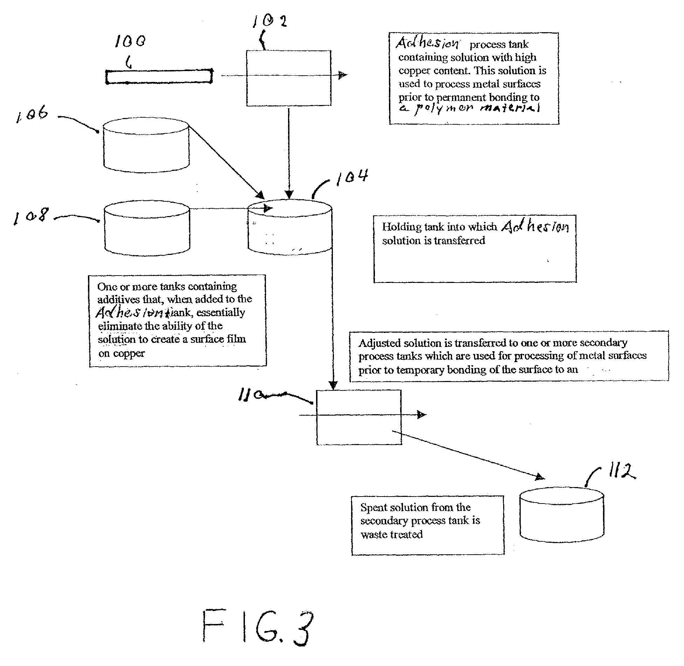

Figure 3 is a schematic of a process flow for oxide replacement baths within the scope of the present invention. Circuit board **100** is treated in process tank **102** to microroughen and form an oxide film on a metal layer of circuit board **100**. Bailout of spent oxide replacement bath from the process tank **102** containing a high metal content is diverted to a holding tank **104** for component modification. High metal content oxide replacement bath is employed to process metal surfaces to receive permanent bonding polymer materials. Such polymer materials may include pre-preg or photoresist used to make permanent articles such as solder masks and the like. The bailout of the spent oxide replacement bath receives additives from tanks **106** and **108** while in holding tank **104**. The additives may be any one or more components discussed above. The resulting modified oxide replacement bath is transferred to a secondary process tank **110** that is used for processing metal surfaces prior to temporary bonding of a polymeric material, such as a temporary photoresist, with the metal surface. While the modified oxide replacement bath microroughens the metal surface, the bath does not produce an undesirable reddish brown to black oxide film. Spent modified oxide replacement bath may be diverted to tank **112** for waste treatment and then disposed. Advantageously, bailout from oxide replacement compositions may be utilized to microroughen a metal surface without waste treatment, thus improving the overall efficiency of using oxide replacement compositions. Bailout from operational oxide replacement baths may be readily modified and used for treating a metal surface.

When copper is the metal to be treated, the copper surface may be contacted with a modified oxide replacement bath without pre-treatment. The copper surface may have been previously provided with a tarnish-inhibiting coating, e.g., by incorporating the tarnish inhibitor into a photoresist stripping composition used in an immediately preceding step of etch photoresist stripping. Tarnish inhibitors used in such strippers are, for example, a triazole or other coating. Pre-cleaner, such as Circubond Cleaner 140® (obtainable from Shipley Company), optionally may be used to pre-clean the copper surface prior to contacting the surface with an oxide replacement bath. Preferably, prior to contact with the modified oxide replacement bath, the copper surface is substantially dry.

A modified oxide replacement composition may be applied to a metal surface such as a copper metal by any conventional means. For example, the metal may be immersed in a bath of the modified oxide replacement bath or by spraying the modified oxide replacement bath on the metal surface. Contact between the oxide replacement solution and the metal surface may be part of a continuous process.

Generally, contact of the metal surface with the modified oxide replacement composition is at a temperature of no greater than about 75° C, preferably the temperature is less than about 50° C. Most preferably, the contact temperature is from about 20° C to about 30° C. Contact time between the metal surface and the modified oxide replacement composition is no less than about 1 second, preferably no less than about 5 seconds, and more preferably at least about 10 seconds. Most preferably, contact is at least about 30 seconds. Maximum contact time between a metal surface and a modified oxide replacement bath is about 5 minutes.

The present invention also is especially useful when a metal such as copper is a foil produced in a drum side treatment process to form a drum side treated foil. Such a foil has a smooth drum side provided with an adhesion enhancing plating and the other side of the foil is rough. Either or both sides may be treated with the present method. Preferably the drum side, at least, is treated. Drum side treated foil is commercially available (and is known as DSTFoil™) from Polyclad Laminates, Inc. of West Franklin, N.H. The foil is provided at least on the drum side with an adhesion enhancing plating, preferably of copper-zinc particles. The foil may be electrodeposited onto a smooth surface and preferably has a nominal conductive thickness in the range of about 2.5 to about 500 µm. The rough (or matte) side that is not coated with an adhesion enhancing plating may have a roughness R_{z} value of less than about 10.2 µm, i.e., the foil is a low profile foil, or less than about 5.1 µm (i.e. a very low profile foil) or the foil may be a standard foil (that is, any roughness value).

After treating a metal surface with the modified oxide replacement composition of the present invention, a temporary photoresist may be applied to the microroughened surface of the metal. A phototool with a desired pattern is placed on the temporary photoresist, and the photoresist is exposed to actinic radiation. The unexposed portions of the photoresist are developed and the exposed copper surfaces are etched. Because modified oxide replacement compositions effectively prevent the formation of reddish brown to black oxide film on treated metal substrates, the problem of resist lock-in is avoided. Inner layer circuit boards prepared using the method of the present invention may be employed in electronic apparatus without concern for electrical shorts and other problems associated with resist lock-in.

The following examples are intended to further illustrate the present invention, but are not intended to limit the scope of the invention.

### Example 1

Panels of FR4/glass-epoxy with copper foil completely covering the surface on one side are treated with modified oxide replacement solution obtained from a spent oxide replacement solution having the composition disclosed in Table 1 below.

A portion of the spent oxide replacement solution with a high copper metal concentration is used to process copper surfaces prior to permanent bonding of a dry film photoresit. The dry film photoresist is processed to form a solder mask. The remainder of the spent oxide replacement solution is shunted to a holding tank for processing as described below.

**Table 1**

| **Component of Adhesion Promotion Composition** | **Amount in Adhesion Promotion Composition** |
|---|---|
| Sulfuric Acid | 5% by Volume |
| Hydrogen Peroxide (50%) | 5% by Volume |
| Benzotriazole | 5 grams/liter |
| Carbowax® MPEG 2000 | 3 grams/liter |
| Sodium Chloride | 40 milligrams/liter |
| Water | Balance |

Copper metal content of the oxide replacement solution is about 500 mg/L. Sodium chloride is added to the oxide replacement solution in the holding tank to increase the sodium chloride content to about 50%, i.e., about 80 milligrams/liter.

The copper panels are treated with the modified oxide replacement solution in a conveyorized flood machine. The modified oxide replacement solution is sprayed onto the copper surfaces and retained on the copper surfaces for about 30 seconds to microroughen the copper surfaces. The temperature at which the process is performed is about 25° C. After treatment, the copper surfaces are washed and dried. The copper surfaces are macroscopically examined for reddish brown to black oxide films. No reddish brown to black oxide films are detectable. The modified oxide replacement solution prevents the formation of the undesirable films on the copper surfaces.

A temporary dry film photoresist is laminated on the microroughened copper surfaces. A phototool having a desired pattern is placed on each dry film photoresist and exposed to actinic radiation. The unexposed portions of the photoresist of each panel are developed with a sodium carbonate developer. The exposed copper surfaces of each panel are examined for photoresist lock-in. No photoresist is detectable on the copper surfaces. Optical and electronic methods known in the art may be employed to detect resist lock-in.

Thus the modified oxide replacement solution prevents metal complex film formation and prevents resist lock-in on a metal surface.

### Example 2

Panels of FR4/glass-epoxy covered on one side with copper foil are treated with modified oxide replacement solutions derived from the spent oxide replacement solutions listed in Table 2 below. The oxide replacement solutions are employed to microroughen metal surfaces for receiving pre-peg layers. A portion of the spent oxide replacement solutions with high copper metal concentrations are then used to process copper metal surfaces prior to permanent bonding of polymer materials to the treated metal surfaces. Such permanent layers of polymer materials are pre-peg layers or a solder mask made from a dry film photoresist. Another portion of each spent oxide replacement solutions is shunted to holding tanks for modification.

**Table 2**

| **Component** | **Composition 1** | **Composition 2** | **Composition 3** | **Composition 4** |
|---|---|---|---|---|
| Hydrogen Peroxide | 3.5%wt. | 3.5%wt. | 3.5%wt. | 3.5%wt. |
| Sulfuric Acid | 8.5%wt. | | | 8.5%wt. |
| Nitric Acid | | 9.5%wt. | | |
| Phosphoric Acid | | | 7.4%wt. | |
| Benzotriazole | 0.68%wt. | 0.68%wt. | 0.68%wt. | 0.68%wt. |
| Tomah® Q 14-2 | | 0.01%wt. | 0.01%wt. | |
| Tomah® Q 17-2 | | | | 0.01%wt. |
| Tomah® E 14-2 | 0.01%wt. | | | |
| Deionized Water | Balance | Balance | Balance | Balance |

Copper metal concentrations of the spent oxide replacement solutions are from about 1000 mg/liter to about 1500 mg/liter. Tomah® is a trade name of a group of surfactants obtainable from Exxon Chemicals. Benzotriazole is a corrosion inhibitor.

Benzotriazole is added to each of the spent solutions in their holding tanks to increase the beznotriazole concentrations to about 5% by weight. The modified oxide replacement solutions are then transferred to their respective secondary process tanks for treating the copper surfaces of the FR4/glass-epoxy panels to receive temporary photoresists.

Treatment of each FR4/glass-epoxy panel is performed in a conveyorized flood machine. Each modified oxide replacement solution is sprayed on a panel and retained on the panel for about 1 minute. The temperature at which the process in performed is about 30° C. Each panel is then examined for formation of the undesirable reddish brown to black oxide film. None of the panels have the film on their microroughened copper surfaces.

Each panel is then laminated with a temporary dry film photoresist. A phototool with a desired pattern is placed on the photoresist and each panel is exposed to actinic radiation. Each panel is then developed with a sodium carbonate developer to remove the unexposed photoresist. The exposed copper surfaces for each panel are examined for resist lock-in. None of the copper panels show evidence of photoresist remaining on the copper surfaces. Thus, the modified oxide replacement solutions prevent both the reddish brown to black oxide film forming on the copper surfaces as well as resist lock-in.

## Claims

1. A method of treating a surface of a metal substrate comprising:
a) changing an amount of at least one component of an oxide replacement composition by a sufficient amount to form a modified oxide replacement composition such that the modified oxide replacement composition does not form a reddish brown to black oxide film on the metal surface when contacting the metal surface; and
b) contacting the metal surface with the modified oxide replacement composition to microroughen the metal surface.

2. The method of claim 1, wherein the at least one component comprises an oxidizer, a corrosion inhibitor, an amine, a surfactant, an acid, a halogen source, a water soluble polymer, or a stabilizing agent.

3. The method of claim 1, wherein the metal substrate comprises copper, nickel, tin, iron, chromium, platinum, lead, gold, silver, cobalt, or alloys thereof.

4. The method of claim 1, further comprising a step of laminating a photoresist on the microroughened metal surface.

5. The method of claim 4, further comprising a step of forming a pattern on the photoresist with a phototool and actinic radiation.

6. The method of claim 5, further comprising steps of developing, etching and stripping unexposed photoresist from the microroughened metal surface of the substrate, the substrate has no resist lock-in.

7. A method of treating a surface of a metal substrate comprising:
a) bailing out a stream of spent oxide replacement composition from an oxide replacement bath;
b) changing an amount of at least one component of the stream of spent of oxide replacement composition by a sufficient amount to form a modified oxide replacement composition such that the modified oxide replacement composition does not form a reddish brown to black oxide film on the metal surface when contacting the metal surface; and
c) contacting the metal surface with the modified oxide replacement composition to microroughen the metal surface.

8. The method of claim 7, wherein the at least one component comprises an oxidizer, a corrosion inhibitor, an amine, a surfactant, an acid, a halogen source, a water soluble polymer, or a stabilizing agent.

9. The method of claim 8, wherein the halogen source comprises sodium chloride, potassium chloride, oxohalides, halide bearing mineral acids or mixtures thereof.

10. The method of claim 8, wherein the corrosion inhibitor comprises a triazole, a benzotriazole, a benzotriazole substituted with C₁₋₄ alky substitutents, tetrazoles, imidazoles, benzimidazoels or mixtures thereof.
